# EUROPÄISCHE PATENTSCHRIFT

(11) **EP 3 448 134 B1**
(45) Veröffentlichungstag und Bekanntmachung des Hinweises auf die Patenterteilung: **15.07.2026**
(21) Anmeldenummer: 18190444.2
(22) Anmeldetag: 23.08.2018
(51) Int. Cl.: H05K 1/02, H01R 13/6587, H01R 13/518, H01R 12/72

(54) **VERWENDUNG EINES VERBINDERSYSTEMS**
USE OF A CONNECTOR SYSTEM
UTILISATION D'UN SYSTÈME DE RACCORD

(30) Priorität: 25.08.2017 DE 102017008087; 25.08.2017 DE 102017008065
(43) Veröffentlichungstag der Anmeldung: 27.02.2019
(73) Patentinhaber: Yamaichi Electronics Deutschland GmbH, 85609 Aschheim-Dornach (DE)
(72) Erfinder: Quiter, Michael, 57482 Wenden (DE); Serrano, Jaime Fernández, 80796 München (DE); Michel, Dirk, 85778 Haimhausen (DE)
(74) Vertreter: Müller-Boré & Partner Patentanwälte PartG mbB

(56) Entgegenhaltungen:
- WO-A1-2010/054750
- DE-A1- 102009 019 137
- US-A- 4 451 107
- US-A1- 2003 109 177
- US-B1- 7 252 513

## Beschreibung

Die Erfindung betrifft die Verwendung eines Verbindersystems zum Verbinden einer PCB-Karte mit einem Zentralrechner eines Kraftfahrzeugs.

Moderne Kraftfahrzeuge werden mit einem Zentralrechner ausgestattet, der diverse Automotive Anwendungen ausführen bzw. steuern kann. Dazu kann der Zentralrechner des Kraftfahrzeugs wie bei einem Mainboard eines PCs oder Notebooks mit einer PCB (Printed Circuit Board) Karte bzw. einer Chipkarte verbunden werden, die für die jeweilige Anwendung spezifisch ist. Es ist daher erforderlich, ein für den Automotive Bereich geeignetes Verbindersystem zwischen einer PCB-Karte und dem Zentralrechner eines Kraftfahrzeugs bereitzustellen.

Im Stand der Technik existieren Netzwerkstecker bzw. Netzwerkverbinder aus dem Bereich der Telekommunikation, die jedoch nicht für den Automotive Bereich konzipiert bzw. geeignet sind. Weiterhin existieren hochpolige Verbinder, die eine Mehrzahl von einzelnen Blechen zur Schirmung der Kontaktelemente aufweisen. Solche Verbinder sind jedoch nicht massentauglich und bereits aus diesem Grund nicht für den Automotive Bereich geeignet.

Das Dokument US 4.451,107 betrifft einen modularen Verbinder mit einem Zinkdruckguss-Gehäuse zum Verbinden eines Daughterboards an ein Motherboard eines Rechners.

Das Dokument DE 10 2009 019 137 A1 offenbart ein Adapterelement zur seriellen Datenübertragung in einem Fahrzeug. Es umfasst ein erstes Gehäuseteil, welches mit einem Schirm verbindbar ist, und ein zweites Gehäuseteil, welches zumindest ein Kontaktelement aufweist. Die beiden Gehäuseteile sind so angeordnet, dass das zweite Gehäuseteil vom ersten Gehäuseteil in einem Bereich umschlossen ist. Das zumindest eine Kontaktelement ist in diesem Bereich mit dem ersten Gehäuseteil elektrisch kontaktiert, wobei das Adapterelement so konfiguriert ist, dass zur Herstellung der Kontaktierung eine Zugänglichkeit von außen gewährleistet ist. Das zweite Gehäuseteil ist vom ersten Gehäuseteil innerhalb eines weiteren Bereichs, welcher sich ebenfalls entlang der Längsachse des Adapterelements erstreckt, beidseitig vom ersten Gehäuseteil umgeben.

Das Dokument WO 2010/054750 A1 offenbart einen HF-Steckverbinder mit einem Außenleiterteil, einem innerhalb des Außenleiterteils angeordneten Innenleiterteil und einem steckseitigen Ende, welches zum steckenden Verbinden mit einem komplementären HF-Steckverbinder ausgebildet ist. Am steckseitigen Ende des HF-Steckverbinders ist ein das Außenleiterteil wenigstens teilweise umgebendes Gehäuse aus einem elektrisch isolierenden Werkstoff, insbesondere ein Kunststoffgehäuse, angeordnet. Das Gehäuse weist eine Durchgangsbohrung auf, in die das Außenleiterteil eingreift. Das Außenleiterteil weist eine erste axiale Sicherung des Gehäuses auf, welche derart ausgebildet ist, dass diese erste axiale Sicherung einen ersten vorbestimmten Abschnitt des Gehäuses bei Montage am Außenleiterteil dehnt. Das Außenleiterteil weist eine zweite axiale Sicherung des Gehäuses auf, welche derart ausgebildet ist, dass diese zweite axiale Sicherung einen zweiten vorbestimmten Abschnitt des Gehäuses bei Montage am Außenleiterteil zusammenpresst.

Dokument US 7,252,513 B1 offenbart eine Steckverbindereinheit mit parallel zu einer Achsrichtung der Steckverbinder ausgerichteten Vorsprüngen, mit deren Hilfe die Steckverbindereinheit senkrecht zur Ebene einer Leiterplatte positioniert wird. Die Steckverbindereinheit weist auf der der Leiterplatte zugewandten Seite Einrichtungen auf, die eine Auflagefläche und/oder Begrenzungsebene bilden, auf der die angrenzende Ebene der Leiterplatte auf der Steckverbindereinheit aufliegt. Die Steckverbindereinheit weist auf einer der Leiterplatte zugewandten Seite zumindest abschnittsweise einen ersten Freiraum auf, der mit mindestens einer Aussparung und/oder Aussparungen versehen ist. Die Aussparungen liegen dabei mit Abstand zur benachbarten Ebene der Leiterplatte und/oder die Außenkontakte der Steckverbinder sind derart querversetzt zueinander angeordnet, dass zwischen den Steckverbindern ein zweiter Freiraum entsteht. Der erste und/oder zweite Freiraum dienen als Raum zum Routing und/oder Bestücken der Leiterplatte.

Es ist daher eine Aufgabe der vorliegenden Erfindung, eine Verwendung eines Verbindersystems zum Verbinden einer PCB-Karte mit einem Zentralrechner eines Kraftfahrzeugs bereitzustellen, welches den Anforderungen im Automotive Bereich, insbesondere hinsichtlich Stabilität, Signalgüte, Frequenzbereich der Signalübertragung und Massentauglichkeit, genügt. Vorteilhafte Ausführungsformen sind Gegenstand der Unteransprüche.

Ein erster Aspekt betrifft eine Verwendung eines Verbindersystems zum Verbinden einer PCB-Karte mit einem Zentralrechner eines Kraftfahrzeugs, wobei das Verbindersystem ein rechnerseitiges Verbinderelement und ein kartenseitiges Verbinderelement aufweist, und wobei das rechnerseitige Verbinderelement aufweist:
- ein rechnerseitiges Zinkdruckguss-Gehäuse mit zumindest einem rechnerseitigen Kontakthohlraum;
- zumindest einen rechnerseitigen Isolierkörper, welcher im montierten Zustand innerhalb des zumindest einen rechnerseitigen Kontakthohlraums angeordnet ist;
- eine Mehrzahl von rechnerseitigen Kontaktelementen, welche im montierten Zustand zumindest bereichsweise innerhalb von rechnerseitigen Isolierhohlräumen in dem zumindest einen rechnerseitigen Isolierkörper angeordnet sind;
und wobei
das kartenseitige Verbinderelement aufweist:
- ein kartenseitiges Zinkdruckguss-Gehäuse mit zumindest einem kartenseitigen Kontakthohlraum;
- zumindest einen kartenseitigen Isolierkörper, welcher im montierten Zustand innerhalb des zumindest einen kartenseitigen Kontakthohlraums angeordnet ist und eine Mehrzahl kartenseitige Isolierhohlräume aufweist, die ausgelegt sind, um im montierten Zustand die rechnerseitigen Kontaktelemente zumindest bereichsweise aufzunehmen;
- eine Mehrzahl von kartenseitigen Kontaktelementen, welche im montierten Zustand zumindest bereichsweise innerhalb der kartenseitigen Isolierhohlräume angeordnet sind und die rechnerseitigen Kontaktelemente elektrisch kontaktieren.

Unter dem Begriff "Verbinden" wird im Rahmen dieser Beschreibung insbesondere ein elektrisches Verbinden verstanden. Dabei kann zusätzlich auch ein physikalisches Verbinden darunter verstanden werden. Unter einem "rechnerseitigen Verbinderelement" wird ein Verbinderelement verstanden, welches ausgelegt ist, um (elektrisch und/oder physikalisch) unmittelbar an einen Zentralrechner angeschlossen zu werden. Entsprechend wird unter einem "kartenseitigen Verbinderelement" ein Verbinderelement verstanden, welches ausgelegt ist, um (elektrisch und/oder physikalisch) unmittelbar an eine PCB-Karte angeschlossen zu werden. Allgemein deutet die Zusatzbezeichnung "rechnerseitig" bei verschiedenen Elementen an, dass diese rechnerseitigen Elemente zu dem rechnerseitigen Verbinderelement gehören und/oder Bestandteil davon sind. Entsprechend deutet die Zusatzbezeichnung "kartenseitig" bei verschiedenen Elementen an, dass diese kartenseitigen Elemente zu dem kartenseitigen Verbinderelement gehören und/oder Bestandteil davon sind.

Der montierte Zustand bezeichnet im Sinne der vorliegenden Beschreibung einen Zustand, in dem das Verbindersystem, das rechnerseitige Verbinderelement und/oder das kartenseitige Verbinderelement bestimmungsgemäß verwendet wird und/oder bestimmungsgemäß montiert, zusammengesetzt oder zusammengesteckt ist. Insbesondere bezeichnet der montierte Zustand, dass das rechnerseitige und kartenseitige Verbinderelement miteinander elektrisch verbunden sind. Der montierte Zustand kann daher auch als zusammengebauter Zustand, zusammengesetzter Zustand, zusammengesteckter Zustand und/oder als Betriebszustand bezeichnet sein. Mit anderen Worten bezeichnet der montierte Zustand eines Verbinderelements bzw. Verbindersystems eine bestimmungsgemäße Anordnung oder Einbauposition der einzelnen Elemente des Verbinderelements und/oder Verbindersystems.

Die PCB-Karte kann insbesondere als eine PCMCIA Express 3.0 und/oder 4.0 Karte ausgebildet sein. Der Begriff "PCB-Karte" kann auch andere Chipkarten betreffen, welche grundsätzlich für die Verwendung im Automotive Bereich geeignet sind.

Das rechnerseitige Verbinderelement weist ein rechnerseitiges Zinkdruckguss-Gehäuse auf. Das rechnerseitige Zinkdruckguss-Gehäuse weist zumindest einen rechnerseitigen Kontakthohlraum auf, bevorzugt eine Mehrzahl von rechnerseitigen Kontakthohlräumen. Der (oder die) rechnerseitige(n) Kontakthohlraum(-räume) sind als Aussparungen im Zinkdruckguss-Gehäuse ausgebildet. Jeder rechnerseitige Kontakthohlraum bildet eine rechnerseitige Kontaktöffnung aus. Mit anderen Worten ist das rechnerseitige Zinkdruckguss-Gehäuse, insbesondere einstückig, aus Zinkdruckguss ausgebildet und/oder gefertigt. Vorzugsweise ist das Zinkdruckguss-Material aus einer Zink-Legierung ausgebildet, insbesondere der Legierung ZP0410, ZP0400 und/oder ZP0430. Diese Legierungen sind z.B. aus der Norm EN 12844 bekannt und dort beschrieben. Alternativ kann das rechnerseitige Zinkdruckguss-Gehäuse aus einem anderen Zinkdruckguss-Material ausgebildet sein. Insbesondere ist das rechnerseitige Zinkdruckguss-Gehäuse einstückig ausgebildet, d.h. es ist nicht aus mehreren Teilen zusammengesetzt, sondern umfasst lediglich ein einziges Teil aus einem Zinndruckguss-Material. Weist das rechnerseitige Gehäuse eine Mehrzahl von rechnerseitigen Kontakthohlräumen auf, so können diese im rechnerseitigen Gehäuse zumindest bereichsweise in Form einer Matrix angeordnet sein. Das rechnerseitige Zinkdruckguss-Gehäuse kann eine Schirmwirkung aufweisen und eine hohe Signalqualität bewirken.

Das rechnerseitige Verbinderelement weist den zumindest einen rechnerseitigen Isolierkörper auf. Dabei kann das rechnerseitige Verbinderelement auch eine Mehrzahl von rechnerseitigen Isolierkörpern aufweisen. Der oder die rechnerseitigen Isolierkörper weisen eine Mehrzahl rechnerseitige Isolierhohlräume auf. Dabei kann einer der rechnerseitigen Isolierkörper entweder eine Mehrzahl der rechnerseitigen Isolierhohlräume aufweisen, oder genau einen der rechnerseitigen Isolierhohlräume. Dies bedeutet für einen Extremfall, in dem das rechnerseitige Verbinderelement genau einen rechnerseitigen Isolierkörper aufweist, dass dieser eine rechnerseitige Isolierkörper alle rechnerseitigen Isolierhohlräume aufweist. Es bedeutet für einen anderen Extremfall, in dem das rechnerseitige Verbinderelement genau so viele rechnerseitige Isolierkörper aufweist wie rechnerseitige Isolierhohlräume, dass jeder rechnerseitige Isolierkörper genau einen rechnerseitigen Isolierhohlraum aufweist. Dazwischen gibt es Ausführungsformen, bei denen z.B. eine Gruppe an rechnerseitigen Isolierkörpern jeweils genau einen rechnerseitigen Isolierhohlraum aufweist, und einer (oder mehrere) weitere(r) rechnerseitige(r) Isolierkörper(n) jeweils mehrere rechnerseitige Isolierhohlräume.

Der oder die rechnerseitige(n) Isolierhohlraum(-räume) ist bzw. sind im montierten Zustand innerhalb des bzw. der rechnerseitigen Kontakthohlraums(-räume) angeordnet. Vorzugsweise ist der zumindest eine rechnerseitige Isolierkörper aus den Materialien PA9T, PA10T und/oder LCP ausgebildet und/oder gefertigt. Die Anzahl der rechnerseitigen Isolierkörper kann z.B. der Anzahl an rechnerseitigen Kontakthohlräumen entsprechen. Die rechnerseitigen Isolierkörper können z.B. etwa rechteckförmig ausgebildet sein, wodurch eine einfache Montage ermöglicht wird.

Zusätzlich weist das rechnerseitige Verbinderelement eine Mehrzahl von rechnerseitigen Kontaktelementen, insbesondere Kontaktstifte, auf. Vorzugsweise sind die rechnerseitigen Kontaktelemente aus CuSn6 oder alternativen Kupferlegierungen ausgebildet und/oder gefertigt. Allgemein sind Kontaktelemente elektrische Leiter, mit denen elektrische Signale übertragen werden können. Die rechnerseitigen Kontaktelemente sind im montierten Zustand zumindest bereichsweise innerhalb der rechnerseitigen Isolierhohlräume des zumindest einen rechnerseitigen Isolierkörpers angeordndet, und damit auch innerhalb des zumindest einen rechnerseitigen Kontakthohlraums. Mit anderen Worten umgibt der zumindest eine rechnerseitige Isolierkörper die rechnerseitigen Kontaktelemente zumindest bereichsweise. "Zumindest bereichsweise" bedeutet in diesem Zusammenhang, dass jeweils zumindest ein Abschnitt eines rechnerseitigen Kontaktelements innerhalb eines rechnerseitigen Isolierhohlraums des zumindest einen rechnerseitigen Isolierkörpers angeordnet ist und/oder dass einer der rechnerseitigen Isolierkörper zumindest einen Abschnitt jedes rechnerseitigen Kontaktelements umgibt. Insbesondere sind die rechnerseitigen Kontaktelemente im montierten Zustand zumindest bereichsweise innerhalb von rechnerseitigen Isolierhohlräumen des zumindest einen rechnerseitigen Isolierkörpers angeordnet, so dass sie gegenüber dem rechnerseitigen Gehäuse elektrisch isoliert sind. Die rechnerseitigen Kontaktelemente können das rechnerseitige Gehäuse im Wesentlichen vollständig durchdringen.

Abgesehen von der isolierenden Wirkung ist der zumindest eine rechnerseitige Isolierkörper auch dazu ausgebildet, die rechnerseitigen Kontaktelemente in dem zumindest einen rechnerseitigen Kontakthohlraum zu halten und/oder zu befestigen. Der zumindest eine Isolierkörper kann somit neben seiner Isolierfunktion auch eine Stabilitätsfunktion aufweisen, d.h. eine Halte- und/oder Befestigungsfunktion. An den Stellen bzw. Abschnitten der Kontaktelemente, die nicht von einem Isolierkörper umgeben sind, kann Luft als Isolator verwendet werden.

Ein Steckende der rechnerseitigen Kontaktelemente kann aus dem rechnerseitigen Gehäuse herausragen und zum Kontaktieren des Zentralrechners ausgebildet sein.

Das kartenseitige Verbinderelement weist ein kartenseitiges Zinkdruckguss-Gehäuse auf. Das kartenseitige Zinkdruckguss-Gehäuse weist zumindest einen kartenseitigen Kontakthohlraum auf, bevorzugt eine Mehrzahl von kartenseitigen Kontakthohlräumen. Der (oder die) kartenseitige(n) Kontakthohlraum(-räume) sind als Aussparung im Zinkdruckguss-Gehäuse ausgebildet. Jeder kartenseitige Kontakthohlraum bildet eine kartenseitige Kontaktöffnung aus.

Das kartenseitige Zinkdruckguss-Gehäuse kann zweistückig ausgebildet sein, d.h. es kann aus genau zwei Teilen aus Zinkdruckguss, nämlich einem ersten kartenseitigen Zinkdruckguss-Gehäuse und einem zweiten kartenseitigen Zinkdruckguss-Gehäuse, zusammengesetzt sein. Alternativ kann auch das kartenseitige Zinkdruckguss-Gehäuse einstückig ausgebildet sein. Vorzugsweise ist das Zinkdruckguss-Material aus einer Zink-Legierung ausgebildet, insbesondere der Legierung ZP0410, ZP0400 und/oder ZP0430. Diese Legierungen sind z.B. aus der Norm EN 12844 bekannt und dort beschrieben. Alternativ kann das kartenseitige Zinkdruckguss-Gehäuse aus einem anderen Zinkdruckguss-Material ausgebildet sein. Das kartenseitige Zinkdruckguss-Gehäuse kann eine (elektrische) Schirmwirkung aufweisen und eine hohe Signalqualität ermöglichen.

Weist das kartenseitigen Gehäuse eine Mehrzahl von kartenseitigen Kontakthohlräumen auf, so können diese im kartenseitigen Gehäuse zumindest bereichsweise in Form einer Matrix angeordnet sein, insbesondere (zumindest bereichsweise) komplementär zu den rechnerseitigen Kontakthohlräumen. Allgemein kann für jeden rechnerseitigen Kontakthohlraum ein zugehöriger bzw. komplementärer kartenseitiger Kontakthohlraum vorgesehen und/oder ausgebildet sein.

Das kartenseitige Verbinderelement weist den zumindest einen kartenseitigen Isolierkörper auf. Dabei kann das kartenseitige Verbinderelement auch eine Mehrzahl von kartenseitigen Isolierkörpern aufweisen. Der oder die kartenseitigen Isolierkörper weisen eine Mehrzahl kartenseitige Isolierhohlräume auf. Dabei kann einer der kartenseitigen Isolierkörper entweder eine Mehrzahl der kartenseitigen Isolierhohlräume aufweisen, oder genau einen der kartenseitigen Isolierhohlräume. Dies bedeutet für einen Extremfall, in dem das kartenseitige Verbinderelement genau einen kartenseitigen Isolierkörper aufweist, dass dieser eine kartenseitige Isolierkörper alle kartenseitigen Isolierhohlräume aufweist. Es bedeutet für einen anderen Extremfall, in dem das kartenseitige Verbinderelement genau so viele kartenseitige Isolierkörper aufweist wie kartenseitige Isolierhohlräume, dass jeder kartenseitige Isolierkörper genau einen kartenseitigen Isolierhohlraum aufweist. Dazwischen gibt es Ausführungsformen, bei denen z.B. eine Gruppe an kartenseitigen Isolierkörpern jeweils genau einen kartenseitigen Isolierhohlraum aufweist, und einer (oder mehrere) weitere(r) kartenseitige(r) Isolierkörper(n) jeweils mehrere kartenseitige Isolierhohlräume.

Der oder die kartenseitige(n) Isolierhohlraum(-räume) ist bzw. sind im montierten Zustand innerhalb des bzw. der kartenseitigen Kontakthohlraums(-räume) angeordnet. Vorzugsweise ist der zumindest eine kartenseitige Isolierkörper aus den Materialien PA9T, PA10T und/oder LCP ausgebildet und/oder gefertigt. Die Anzahl der kartenseitigen Isolierkörper kann z.B. der Anzahl an kartenseitigen Kontakthohlräumen entsprechen. Die kartenseitigen Isolierkörper können z.B. bereichsweise rechteckförmig ausgebildet sein, wodurch eine einfache Montage ermöglicht werden kann.

Der oder die kartenseitigen Isolierkörper weisen kartenseitige Isolierhohlräume auf, die ausgelegt sind, um im montierten Zustand die rechnerseitigen Kontaktelemente zumindest bereichsweise aufzunehmen. Mit anderen Worten dringen im montierten Zustand die rechnerseitigen Kontaktelemente in den zumindest einen kartenseitigen Isolierkörper ein, um die kartenseitigen Kontaktelemente zu kontaktieren. Die Anzahl der kartenseitigen Isolierkörper kann der Anzahl von kartenseitigen Kontakthohlräumen entsprechen. Weiter kann die Anzahl von rechnerseitigen Kontakthohlräumen der Anzahl von kartenseitigen Kontakthohlräumen entsprechen.

Zusätzlich weist das kartenseitige Verbinderelement eine Mehrzahl von kartenseitigen Kontaktelementen auf. Vorzugsweise sind die kartenseitigen Kontaktelemente aus CuSn6 oder alternativen Kupferlegierungen ausgebildet bzw. gefertigt. Die kartenseitigen Kontaktelemente sind im montierten Zustand zumindest bereichsweise innerhalb von den kartenseitigen Isolierhohlräumen des zumindest einen kartenseitigen Isolierkörpers angeordnet, und damit auch innerhalb des zumindest einen kartenseitigen Kontakthohlraums. Mit anderen Worten umgibt der zumindest eine kartenseitige Isolierkörper die kartenseitigen Kontaktelemente zumindest bereichsweise. Der Begriff "zumindest bereichsweise" bedeutet in diesem Zusammenhang, dass jeweils zumindest ein Abschnitt eines kartenseitigen Kontaktelements innerhalb eines kartenseitigen Isolierhohlraums eines kartenseitigen Isolierkörpers angeordnet ist und/oder dass ein kartenseitiger Isolierkörper zumindest einen Abschnitt eines kartenseitigen Kontaktelements umgibt. Insbesondere sind die kartenseitigen Kontaktelemente im montierten Zustand zumindest bereichsweise innerhalb von kartenseitigen Isolierhohlräumen des zumindest einen kartenseitigen Isolierkörpers angeordnet, so dass sie gegenüber dem kartenseitigen Gehäuse elektrisch isoliert sind. Die kartenseitigen Kontaktelemente sind derart ausgelegt und angeordnet, dass sie im montierten Zustand jeweils zugehörige rechnerseitige Kontaktelemente kontaktieren. Die Kontaktierung der rechnerseitigen und kartenseitigen Kontaktelemente erfolgt insbesondere innerhalb der kartenseitigen Kontakthohlräume und/oder innerhalb der kartenseitigen Isolierkörper. Alternativ kann die Kontaktierung der rechnerseitigen und kartenseitigen Kontaktelemente innerhalb der rechnerseitigen Kontakthohlräume und/oder innerhalb der rechnerseitigen Isolierkörper erfolgen.

Ein Steckende der kartenseitigen Kontaktelemente kann aus dem kartenseitigen Gehäuse herausragen und zum Kontaktieren der PCB-Karte ausgebildet sein.

Abgesehen von der isolierenden Wirkung kann der zumindest eine kartenseitige Isolierkörper dazu ausgebildet sein, die kartenseitigen Kontaktelemente in dem zumindest einen kartenseitigen Kontakthohlraum zu halten und/oder zu befestigen. Der zumindest eine kartenseitige Isolierkörper kann sowohl eine Isolierfunktion als auch eine Stabilitätsfunktion aufweisen und/oder erfüllen. An den Stellen bzw. Abschnitten der kartenseitigen Kontaktelemente, die nicht von einem kartenseitigen Isolierkörper umgeben sind, kann Luft als Isolator verwendet werden.

Bei dem erfindungsgemäßen Verbindersystem weist das rechnerseitige Verbinderelement und/oder das kartenseitige Verbinderelement jeweils ein Zinkdruckguss-Gehäuse mit jeweils zumindest einem Kontakthohlraum auf. Dadurch kann im montierten Zustand eine durchgängige Abschirmwirkung auf Grund der von den Zinkdruckguss-Gehäusen umgebenenen Hohlräumen erzielt werden, in welchen sich die signalübertragenden Kontaktelemente befinden. Im Rahmen der vorliegenden Erfindung hat sich gezeigt, dass die erfindungsgemäßen Verbinderelemente und/oder das erfindungsgemäße Verbindersystem den eingangs aufgeführten Anforderungen im Automotive Bereich genügen. Zudem können die Verbinderelemente und somit das Verbindersystem schnell und einfach im Zinkdruckguss hergestellt werden, so dass sie im Vergleich zu herkömmlichen Verbindern, die den Anforderungen im Automotive Bereich genügen, auch massentauglich sind. Durch die Ausbildung der Gehäuse im Zinkdruckguss kann sowohl eine elektrische Abschirmung, eine massentaugliche Herstellung und eine vibrationsbeständige Festigkeit erreicht werden.

Gemäß einer Ausführungsform weist zumindest ein Gehäuse vom rechnerseitigen Zinkdruckguss-Gehäuse und vom kartenseitigen Zinkdruckguss-Gehäuse zumindest eine Schrauböffnung auf zum Festschrauben des jeweiligen Zinkdruckguss-Gehäuses an der PCB-Karte und/oder an dem Zentralrechner, wobei die Schrauböffnung als eine Zinkdruckguss-Schrauböffnung ausgebildet ist. Die Schrauböffnung kann einstückig zusammen mit dem jeweiligen Gehäuse ausgebildet sein. Die Schrauböffnung kann als ein schlaufenartiges Anhängsel und/oder als ein Fortsatz an einem Gehäuserand ausgebildet sein. Die Schrauböffnung weist eine durchgehende, im Wesentlichen runde Öffnung auf, deren Innendurchmesser auf ein Schraubgewinde einer vorbestimmten Schraube abgestimmt sein kann. Diese vorbestimmte Schraube weist einen Gewindeabschnitt auf, der durch die Schrauböffnung hindurch passt und einen Schraubkopf, der nicht durch die Schrauböffnung hindurch passt. Die Schrauböffnung kann einen Zylinderabschnitt umschließen und/oder definieren, in den die vorbestimmte Schraube eingeschraubt werden kann. Bevorzugt weist das jeweilige Gewinde zumindest zwei solcher Schrauböffnungen auf, so dass das jeweilige Gehäuse noch stabiler und sicherer mit der PCB-Karte und/oder dem Zentralrechner verschraubt werden kann.

Bevorzugt weist zumindest das rechnerseitige Verbinderelement die zumindest eine Schrauböffnung auf, um das rechnerseitige Zinkdruckguss-Gehäuse mit dem Zentralrechner zu verschrauben.

Dadurch wird eine Verschraubung des Zinkdruckguss-Gehäuses des jeweiligen Verbinderelements ermöglicht, wodurch die Befestigung gegen Vibration(en) und/oder andere Belastungen gesichert wird. Die Ausbildung der zumindest einen Schrauböffnung aus Zinkdruckguss zusammen mit dem jeweiligen Zinkdruckguss-Gehäuse ist massentauglich herzustellen und verbessert die Vibrationsbeständigkeit des Verbindersystems.

Gemäß einer Weiterbildung ist die zumindest eine Schrauböffnung parallel zur einer Einsteckrichtung des jeweiligen Zinkdruckguss-Gehäuses in die PCB-Karte und/oder den Zentralrechner ausgerichtet. So kann die Schrauböffnung des rechnerseitigen Verbinderelements etwa parallel zu einer Einsteckrichtung des rechnerseitigen Verbinderelements in den Zentralrechner und/oder parallel zu einer ersten Montagerichtung der beiden Verbinderelemente aneinander ausgebildet sein. Die Schrauböffnung des kartenseitigen Verbinderelements kann etwa parallel zu einer zweiten Montagerichtung des kartenseitigen Verbinderelements in die PCB-Karte ausgebildet sein. Dies bedeutet, dass die Schraube zum Verschrauben des Zinkdruckguss-Gehäuses des jeweiligen Verbinderelements etwa parallel zu den Steckenden der Kontaktelemente des jeweiligen Verbinderelements in den Zentralrechner bzw. die PCB-Karte eingeschraubt werden können.

Gemäß einer Weiterbildung weist das Zinkdruckguss-Gehäuse mit der Schrauböffnung zumindest zwei Schrauböffnungen auf. Die Schrauböffnungen können beabstandet voneinander und/oder etwa parallel zueinander ausgebildet sein. Dies bedeutet, dass Zylinderachsen von von den Schrauböffnungen umschlossenen Zylinderabschnitten etwa parallel zueinander ausgerichtet sind. Die Vorsehung von zumindest zwei Schrauböffnungen am selben Verbinderelement verbessert die Befestigung und Sicherung des Verbindersystems.

In einer Ausführungsform ist das rechnerseitige Verbinderelement ausgelegt, um entlang einer ersten Montagerichtung mit dem Zentralrechner verbunden, insbesondere zusammengesteckt, zu werden. Das kartenseitige Verbinderelement ist ausgelegt, um entlang einer zweiten Montagerichtung mit der PCB-Karte verbunden, insbesondere zusammengesteckt, zu werden. Ferner können das rechnerseitige Verbinderelement und das kartenseitige Verbinderelement entlang der ersten Montagerichtung verbindbar bzw. zusammensteckbar sein. Vorzugsweise unterscheidet sich die erste Montagerichtung von der zweiten Montagerichtung. Insbesondere kann die erste Montagerichtung im Wesentlichen senkrecht zur zweiten Montagerichtung ausgebildet sein.

In einer weiteren Ausführungsform sind die kartenseitigen Kontaktelemente (z.B. genauso wie zugehörige kartenseitige Kontakthohlräume) jeweils gebogen ausgebildet, so dass sie eine im Wesentlichen rechtwinklige Kante aufweisen. Mit anderen Worten sind die kartenseitigen Kontaktelemente im Wesentlichen rechtwinklig ausgebildet. Eine im Wesentlichen rechtwinklige Kante bedeutet im Rahmen dieser Erfindung, dass Abschnitte der kartenseitigen Kontakthohlräume bzw. der kartenseitigen Kontaktelemente vor und nach der "Kante" im rechten Winkel zueinander stehen. Dabei ist die "Kante" selbst bzw. der Bereich, in dem sich die Richtung ändert, in der Regel nicht ideal rechtwinklig ausgebildet, sondern kann vielmehr eine Rundung aufweisen. Die kartenseitigen Kontaktelemente sind im montierten Zustand derart angeordnet, dass ein verbinderseitiger Abschnitt jedes kartenseitigen Kontaktelements im Wesentlichen parallel zur ersten Montagerichtung ausgebildet ist und ein kartenseitiger Abschnitt jedes kartenseitigen Kontaktelements im Wesentlichen parallel zur zweiten Montagerichtung ausgebildet ist, wobei die erste Montagerichtung im Wesentlichen senkrecht zur zweiten Montagerichtung angeordnet ist.

Im Rahmen der Erfindung soll insbesondere bedeuten, dass "im Wesentlichen" und "etwa" eine Eigenschaft erfüllt wird, wenn diese Eigenschaft zu zumindest 90% erfüllt wird, bevorzugt zu zumindest 95%, besonders bevorzugt zu zumindest 99%. Insbesondere kann diese Eigenschaft zu 100% erfüllt sein.

In einer Weiterbildung sind die im Wesentlichen rechtwinklige Kanten im montierten Zustand derart angeordnet, dass die im Wesentlichen rechtwinkligen Kanten zumindest eines Teils der kartenseitigen Kontaktelemente auf einer Geraden in einer von der ersten und zweiten Montagerichtung (bzw. von entsprechenden Richtungsvektoren) aufgespannten Ebene liegen, wobei die Gerade sowohl zur ersten Montagerichtung als auch zur zweiten Montagerichtung, d.h. zu den entsprechenden Richtungsvektoren, einen Winkel von etwa 45° aufweist. Im Rahmen der vorliegenden Erfindung hat sich gezeigt, dass mit einer derartigen Ausführungsform den Anforderungen im Automotive Bereich, insbesondere hinsichtlich der notwendigen Signalqualität einerseits und einer möglichst hohen Platzeinsparung andererseits, besonders gut gerecht werden kann.

In einer weiteren Ausführungsform weist das rechnerseitige Gehäuse zumindest ein Eingriffelement auf, welches im montierten Zustand in zumindest ein komplementäres Eingriffelement des kartenseitigen Gehäuses eingreift. Das Eingriffelment kann z.B. ein Vorsprung sein und das komplementäre Eingriffelement eine zugehörige Öffnung. Auf diese Weise wird eine stabile und zugleich kontinuierliche bzw. durchgehende Verbindung der rechnerseitigen und kartenseitigen Kontakthohlräume geschaffen bzw. unterstützt. Dies bewirkt vorteilhafterweise eine hohe Stabilität sowie gleichzeitig eine durchgehende Schirmwirkung. Die Qualität der Signalübertragung zwischen der PCB-Karte und dem Zentralrechner kann dadurch erhöht werden und genügt insbesondere den Anforderungen im Automotive Bereich.

In einer weiteren Ausführungsform weisen die kartenseitigen Kontaktelemente jeweils wellenförmige Endabschnitte auf, um bei einem Überlapp mit einem zugehörigen rechnerseitigen Kontaktelement das zugehörige rechnerseitige Kontaktelement an zumindest zwei unterschiedlichen Stellen elektrisch zu kontaktieren. Auch wenn in Folge der wellenartigen Abschnitte eine antennenartige Wirkung und somit Störsignale erwartet werden könnten, so hat sich im Rahmen der vorliegenden Erfindung überraschenderweise herausgestellt, dass dadurch die Qualität für die im Automotive Bereich übertragenen Signale bzw. Frequenzen nicht nennenswert beeinträchtigt werden. Vielmehr kann die Signalübertragung durch die wellenartige Form der kartenseitigen Kontaktelemente, insbesondere hinsichtlich Zuverlässigkeit, gesteigert werden, ohne dass die Kontaktstelle z.B. aufwendig verlötet werden muss.

In einer weiteren Ausführungsform weist das rechnerseitige Gehäuse zumindest ein Stabilisierungselement und das kartenseitige Gehäuse zumindest ein komplementäres Stabilisierungselement auf. Das zumindest eine Stabilisierungselement kann z.B. eine Aussparung oder eine Nut umfassen, während das komplementäre Stabilisierungselement einen Vorsprung, insbesondere einen Stabilisierungsstift bzw. einen Steckstift, welcher mit der Aussparung oder der Nut in Eingriff bringbar ist, umfassen kann. Auf diese Weise kann eine erhöhte Stabilität des Verbindersystems erreicht werden, was vor allem im Automotive Bereich wichtig ist, um einen Signalausfall zu vermeiden. Ferner dienen die Stabilisatoren zusätzlich als Steckhilfe.

Alternativ oder zusätzlich weist das kartenseitige Gehäuse zumindest ein Führungselement und das rechnerseitige Gehäuse zumindest ein komplementäres Führungselement auf. Das Führungselement kann z.B. einen Führungsvorsprung oder eine Führungsnut umfassen, während das komplementäre Führungselement entsprechend eine Führungsnut oder einen Führungsvorsprung umfassen kann. Das zumindest eine Führungselement kann die Montage des Verbindersystems erleichtern.

In einer weiteren Ausführungsform weist das kartenseitige Gehäuse Lötstellen auf, um auf die PCB-Karte gelötet zu werden. Auch dies bewirkt eine verbesserte Schirmung und damit eine verbesserte Signalqualität des Verbindersystems.

In einer Ausführungsform umfasst das rechnerseitige Gehäuse einen rechnerseitigen Power-Kontakthohlraum, einen rechnerseitigen Single-End-Kontakthohlraum und eine Mehrzahl von rechnerseitigen Differential-Pair-Kontakthohlräumen. Ferner umfasst der zumindest eine rechnerseitige Isolierkörper einen rechnerseitigen Power-Isolierkörper, welcher im montierten Zustand in dem rechnerseitigen Power-Kontakthohlraum angeordnet ist, einen rechnerseitigen Single-End-Isolierkörper, welcher im montierten Zustand in dem rechnerseitigen Single-End-Kontakthohlraum angeordnet ist, und eine Mehrzahl von rechnerseitigen Differential-Pair-Isolierkörpern, welche im montierten Zustand jeweils in einem zugehörigen rechnerseitigen Differential-Pair-Kontakthohlraum der Mehrzahl von rechnerseitigen Differential-Pair-Kontakthohlräumen angeordnet ist. Ferner umfasst die Mehrzahl von rechnerseitigen Kontaktelementen eine Mehrzahl von rechnerseitigen Power-Kontaktelementen, welche im montierten Zustand zumindest bereichsweise in Isolierhohlräumen des rechnerseitigen Power-Isolierkörpers angeordnet sind, eine Mehrzahl von rechnerseitigen Single-End-Kontaktelementen, welche im montierten Zustand zumindest bereichsweise in Isolierhohlräumen des rechnerseitigen Single-End-Isolierkörpers angeordnet sind, und eine Mehrzahl von rechnerseitigen Differential-Pair-Kontaktelementen, welche im montierten Zustand jeweils zumindest bereichsweise in einem Isolierhohlraum eines zugehörigen rechnerseitigen Differential-Pair-Isolierkörpers der Mehrzahl von rechnerseitigen Differential-Pair-Isolierkörpern angeordnet sind.

Entsprechend umfasst das kartenseitige Gehäuse einen kartenseitigen Power-Kontakthohlraum, einen kartenseitigen Single-End-Kontakthohlraum und eine Mehrzahl von kartenseitigen Differential-Pair-Kontakthohlräumen. Ferner umfasst der zumindest eine kartenseitige Isolierkörper einen kartenseitigen Power-Isolierkörper, welcher im montierten Zustand in dem kartenseitigen Power-Kontakthohlraum angeordnet ist, einen kartenseitigen Single-End-Isolierkörper, welcher im montierten Zustand in dem kartenseitigen Single-End-Kontakthohlraum angeordnet ist, und eine Mehrzahl von kartenseitigen Differential-Pair-Isolierkörpern, welche im montierten Zustand jeweils in einem zugehörigen kartenseitigen Differential-Pair-Kontakthohlraum der Mehrzahl von kartenseitigen Differential-Pair-Kontakthohlräumen angeordnet ist. Ferner umfasst die Mehrzahl von kartenseitigen Kontaktelementen eine Mehrzahl von kartenseitigen Power-Kontaktelementen, welche im montierten Zustand zumindest bereichsweise in Isolierhohlräumen des kartenseitigen Power-Isolierkörpers angeordnet sind, eine Mehrzahl von kartenseitigen Single-End-Kontaktelementen, welche im montierten Zustand zumindest bereichsweise in Isolierhohlräumen des kartenseitigen Single-End-Isolierkörpers angeordnet sind, und eine Mehrzahl von kartenseitigen Differential-Pair-Kontaktelementen, welche im montierten Zustand jeweils zumindest bereichsweise in einem Isolierhohlraum eines zugehörigen kartenseitigen Differential-Pair-Isolierkörpers der Mehrzahl von kartenseitigen Differential-Pair-Isolierkörpern angeordnet sind.

Beispielsweise können in dem rechnerseitigen Gehäuse etwa 40 bis 60, insbesondere 48, rechnerseitige und in dem kartenseitigen Gehäuse etwa 40 bis 60, insbesondere 48, kartenseitige Differential-Pair-Kontakthohlräume ausgebildet sein. Entsprechend können etwa 40 bis 60, insbesondere 48, rechnerseitige und etwa 40 bis 60, insbesondere 48, kartenseitige Differential-Pair-Isolierkörper sowie etwa 40 bis 60, insbesondere 48, rechnerseitige und etwa 40 bis 60, insbesondere 48, kartenseitige Differential-Pair-Kontaktelemente ausgebildet sein, wobei jedes Differential-Pair-Kontaktelement zwei Kontaktelemente umfasst. Es können z.B. etwa 5 bis 15, insbesondere 8, Paar rechnerseitige und entsprechend etwa 5 bis 15, insbesondere 8, Paar kartenseitige Powerkontaktelemente ausgebildet sein. Es können z.B. etwa 40 bis 70, insbesondere 56, rechnerseitige und etwa 40 bis 70, insbesondere 56, kartenseitige Single-End-Kontaktelemente ausgebildet sein.

Vorteilhafterweise sind sämtliche Power-Kontakthohlräume, Power-Isolierkörper und Power-Kontaktelemente auf einer Seite, d.h. in einem (z.B. lateralen) Endabschnitt des rechnerseitigen und/oder kartenseitigen Verbinderelements und Gehäuses angeordnet. Somit können Störeinflüsse bei der Signalübertragung reduziert oder vermieden werden. Weiterhin entsteht dadurch der Vorteil, dass bei dem mit dem Verbindersystem zu verbindenden Zentralrechner und bei der mit dem Verbindersystem zu verbindenden PCB-Karte die dort verlaufenden breiten Powerleitungen und somit auch sämtliche Verbraucher auf einer Seite des Zentralrechners bzw. der PCB-Karte angeordnet werden können. Würden hingegen die Powerleitungen an verschiedenen Stellen, d.h. nicht nur auf einer Seite, des Verbindersystems angeordnet sein, so müssten die Powerleitungen im Zentralrechner und/oder auf der PCB-Karte gekreuzt verlaufen, was insgesamt zu einem höheren Platzbedarf führen würde.

Im Folgenden werden einzelne Ausführungsformen zur Lösung der Aufgabe anhand der Figuren beispielhaft beschrieben. Hierbei können gleiche oder ähnliche Bezugszeichen gleiche oder ähnliche Merkmale der Ausführungsformen kennzeichnen. Einzelne in den Figuren gezeigte Merkmale können in anderen Ausführungsbeispielen implementiert sein. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.
- Figur 1: zeigt in einer perspektivischen Explosionsansicht eine schematische Skizze eines Verbindersystems;
- Figur 2A: zeigt in einer ersten perspektivischen Ansicht (Vorderansicht) eine schematische Skizze des rechnerseitigen Gehäuses des Verbindersystems aus Figur 1;
- Figur 2B: zeigt in einer zweiten perspektivischen Ansicht (Rückansicht) eine schematische Skizze des rechnerseitigen Gehäuses des Verbindersystems aus Figur 1; und
- Figur 3: zeigt in der perspektivischen Ansicht aus Figur 2A (Vorderansicht) eine schematische Skizze des rechnerseitigen Verbinderelements des Verbindersystems aus Figur 1 ohne das rechnerseitige Gehäuse.

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen. Die Zusatzbezeichnung "rechnerseitig", wie sie in der vorliegenden Beschreibung für verschiedene Elemente verwendet wird, bedeutet, dass diese Elemente zu dem rechnerseitigen Verbinderelement, d.h. einem Verbinderelement, welches unmittelbar mit dem Zentralrechner verbunden werden kann, gehören. Entsprechend bedeutet die Zusatzbezeichnung "kartenseitig" bei verschiedenen Elementen an, dass diese Elemente zu dem kartenseitigen Verbinderelement gehören, d.h. einem Verbinderelement, welches unmittelbar mit einer PCB-Karte verbunden werden kann.

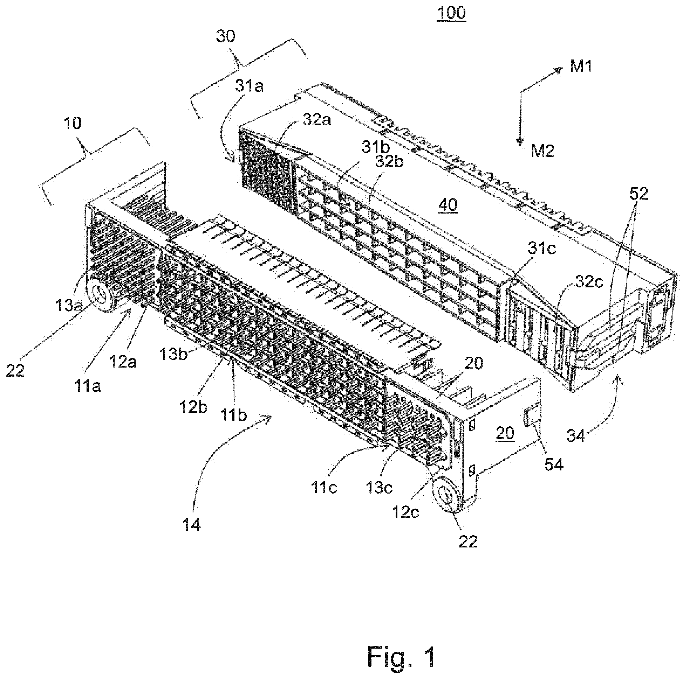

Die **Figur 1** zeigt in einer perspektivischen Explosionsansicht eine schematische Skizze eines erfindungsgemäßen Verbindersystems 100. In dieser Explosionsansicht ist ein rechnerseitiges Verbinderelement 10 und ein kartenseitiges Verbinderelement 30 des Verbindersystems 100 separat, d.h. in einem nicht zusammengesteckten Zustand gezeigt. Im vollständig montierten Zustand sind das rechnerseitige Verbinderelement 10 und das kartenseitige Verbinderelement 30 miteinander verbunden, d.h. entlang einer mit einem Pfeil gekennzeichneten ersten Montagerichtung M1 zusammengesteckt.

Das rechnerseitige Verbinderelement 10 ist ausgelegt, um mit einer rechnerseitigen Steckseite 14 voran an einen Zentralrechner eines Kraftfahrzeugs (nicht gezeigt) angeschlossen bzw. angesteckt zu werden. Im gezeigten Ausführungsbeispiel ist die Steckseite 14 im montierten Zustand diejenige Seite des rechnerseitigen Verbinderelements 10, welche dem kartenseitigen Verbinderelement 30 abgewandt ist. Eine Normale auf die rechnerseitige Steckseite 14 ist etwa entgegengesetzt parallel zur ersten Montagerichtung M1 angeordnet.

Das rechnerseitige Verbinderelement 10 weist eine Mehrzahl von Kontaktelementen 13a, 13b und 13c auf, die mit komplementären Kontaktelementen des Zentralrechners verbunden werden können. Im Ausführungsbeispiel der Figur 1 weist das Verbindersystem 100 bzw. das rechnerseitige Verbinderelement 10 (und analog dazu das kartenseitige Verbinderelement 30) drei unterschiedliche Kontaktbereiche auf, nämlich einen Single-End-Kontaktbereich mit einer Mehrzahl Single-End-Kontaktelementen 13a, einen Differential-Pair-Kontaktbereich mit einer Mehrzahl Differential-Pair-Kontaktelementen 13b und einen Power-Kontaktbereich mit einer Mehrzahl Power-Kontaktelementen 13c. Während die Single-End-Kontaktelemente 13a Signale bzw. Informationen jeweils nur über einen elektrischen Leiter übertragen, so werden bei den Differential-Pair-Kontaktelementen 13b jeweils zwei elektrische Leiter verwendet, um ein Differenzsignal dieser beiden Leiter zu übertragen. Die Power-Kontaktelemente 13c sind im gezeigten Ausführungsbeispiel ähnlich wie die Differential-Pair-Kontaktelemente jeweils paarweise ausgeführt und dienen zur Leistungsübertragung.

Das rechnerseitige Verbinderelement 10 weist ein rechnerseitiges Gehäuse 20 mit einer Mehrzahl von rechnerseitigen Kontakthohlräumen 11a, 11b, und 11c auf, nämlich einem rechnerseitigen Single-Pair-Kontakthohlraum 11a, einer Mehrzahl (hier genau 48) rechnerseitige Differential-Pair-Kontakthohlräume 11b und einen rechnerseitigen Power-Kontakthohlraum 11c. Sämtliche Kontakthohlräume 11a-11c sind durch das rechnerseitige Gehäuse 20 hindurch verlaufend ausgebildet und durchdringen somit das rechnerseitige Gehäuse 20 vollständig. Die Kontakthohlräume 11a-11c weisen (in erster Montagerichtung M1, siehe unten) einen etwa konstanten Querschnitt auf, welcher z.B. etwa rechteckig ausgebildet ist. Ferner weist das rechnerseitige Verbinderelement 10 eine Mehrzahl von rechnerseitigen Isolierkörpern 12a, 12b und 12c auf, welche jeweils zumindest einen Isolierraum ausbilden und umschließen, der durch das rechnerseitige Gehäuse 20 hindurch verlaufend ausgebildet ist.

Die Isolierkörper 12a, 12b und 12c sind innerhalb der rechnerseitigen Kontakthohlräume 11a-11c angeordnet. Im gezeigten Ausführungsbeispiel weist das rechnerseitige Verbinderelement 10 einen rechnerseitigen Single-Pair-Isolierkörper 12a auf, eine Mehrzahl (hier genau 48) rechnerseitige Differential-Pair-Isolierkörper 12b und einen rechnerseitigen Power-Isolierkörper 12c.

Die rechnerseitigen Kontaktelemente 13a-13c sind im montierten Zustand zumindest bereichsweise innerhalb von rechnerseitigen Isolierhohlräumen der jeweils zugehörigen rechnerseitigen Isolierkörper 12a-12c angeordnet. So sind die Single-End-Kontaktelemente 13a im Single-End-Kontakthohlraum 11a und innerhalb von Isolierhohlräumen des Single-End-Isolierkörpers 12a angeordnet. Die Differential-Pair-Kontaktelemente 13b sind jeweils in zugehörigen Differential-Pair-Kontakthohlräumen 11b und innerhalb von zugehörigen Isolierhohlräumen der Differential-Pair-Isolierkörper 12b angeordnet. Die Power-Kontaktelemente 13c sind in dem Power-Kontakthohlraum 11c und jeweils innerhalb von zugehörigen Isolierhohlräumen des Power-Isolierkörpers 12c angeordnet.

Das rechnerseitige Gehäuse 20 weist zumindest eine Schrauböffnung 22 auf, im gezeigten Ausführungsbeispiel genau zwei Schrauböffnungen 22. Jede Schrauböffnung 22 ist einstückig mit dem Gehäuse 20 als Zinkdruckgussbauteil ausgebildet. Die Schrauböffnungen 22 sind an einem Rand der rechnerseitigen Steckseite 14 des rechnerseitigen Gehäuses 20 ausgebildet. Dabei weist jede Schrauböffnung 22 eine kreisförmige Umrandung auf, welche einen Hohlzylinderabschnitt umgibt, in welchen eine Schraube eingeschraubt werden kann. Die Zylinderachse des Hohlzylinderabschnitts ist etwa parallel zur ersten Montagerichtung M1 und/oder zu den kartenseitigen Kontaktelementen 13a-13c angeordnet. Somit kann das rechnerseitige Gehäuse 20 mittels in die Schrauböffnungen 22 geschraubte Schrauben an dem (nicht gezeigten) Zentralrechner befestigt werden. Dabei werden die Schrauben in etwa parallel zu den rechnerseitigen Kontaktelementen 13a-13c durch die Schrauböffnungen geschraubt. Dadurch wird die Befestigung des rechnerseitigen Verbinderelements 10 am Zentralrechner verstärkt und/oder gesichert.

Das kartenseitige Verbinderelement 30 ist ausgelegt, um mit einer PCB-Karte entlang einer zweiten Montagerichtung M2 verbunden zu werden. Dazu weist das kartenseitige Verbinderelement 30 auf seiner Unterseite, der kartenseitigen Steckseite 34, rechnerseitigen Kontaktelementen 13a-13c entsprechende kartenseitige Kontaktelemente auf (nicht gezeigt). Dabei sind die kartenseitigen Kontaktelemente etwa rechtwinklig ausgebildet mit einem ersten Abschnitt, der sich etwa parallel zur ersten Montagerichtung M1 erstreckt, und einem zweiten Abschnitt, der sich etwa parallel zur zweiten Montagerichtung M2 erstreckt. Der zweite Abschnitt der kartenseitigen Kontaktelemente kann hierbei aus der kartenseitigen Steckseite 34 herausragen zum (elektrischen und/oder physikalischen) kontaktieren der PCB-Karte.

Wie in der Figur 1 gezeigt, ist die zweite Montagerichtung M2 im Wesentlichen senkrecht zur ersten Montagerichtung M1 ausgerichtet. Das kartenseitige Verbinderelement 30 ist dazu ausgebildet und vorgesehen, mit seiner kartenseitigen Steckseite 34 voran in Richtung der zweiten Montagerichtung M2 an der (nicht gezeigten) PCB-Karte befestigt, z.B. verlötet, zu werden. Die kartenseitige Steckseite 34 ist im montierten Zustand in einer Ebene angeordnet, die etwa senkrecht zu der Ebene angeordnet ist, in der die rechnerseitige Steckseite 14 angeordnet ist.

Das kartenseitige Verbinderelement 30 weist ein kartenseitiges Gehäuse 40 mit einer Mehrzahl von kartenseitigen Kontakthohlräumen 31a-31c auf. Dabei kann das kartenseitige Gehäuse 40 einstückig ausgebildet sein oder zumindest zwei kartenseitige Gehäuseelemente aufweisen., welche miteinander verbunden bzw. zusammengesteckt werden können.

Das kartenseitige Gehäuse 40 weist eine Mehrzahl von kartenseitigen Isolierkörpern 32a-32c auf, welche im montierten Zustand innerhalb der kartenseitigen Kontakthohlräume 31a-31c angeordnet sind. Die kartenseitigen Isolierkörper 32a-32c wiederum weisen kartenseitige Isolierhohlräume auf, die ausgelegt sind, um im montierten Zustand zugehörige rechnerseitige Kontaktelemente 13a-13c zumindest bereichsweise aufzunehmen. Sowohl die kartenseitigen Kontakthohlräume 31a-31c, die kartenseitigen Isolierkörpern 32a-32c, als auch die kartenseitigen Kontaktelemente sind winklig ausgebildet. Die kartenseitigen Kontakthohlräume 31a-31c usw. weisen dabei einen ersten Abschnitt auf, welcher etwa parallel zur ersten Montagerichtung M1 ausgebildet ist, und einen zweiten Abschnitt, welcher etwa parallel zur zweiten Montagerichtung M2 ausgebildet ist.

Im gezeigten Ausführungsbeispiel weist das kartenseitige Verbinderelement 30 einen kartenseitigen Single-Pair-Isolierkörper 32a, eine Mehrzahl (hier genau 48) kartenseitige Differential-Pair-Isolierkörper 32b und einen kartenseitigen Power-Isolierkörper 32c auf. Die kartenseitigen Kontaktelemente (nicht in Figur 1 gezeigt) sind im montierten Zustand zumindest bereichsweise innerhalb von kartenseitigen Isolierhohlräumen der jeweils zugehörigen kartenseitigen Isolierkörper 32a-32c angeordnet. So sind Single-End-Kontaktelemente im Single-End-Kontakthohlraum 31a und innerhalb von Isolierhohlräumen des Single-End-Isolierkörpers 32a angeordnet. Differential-Pair-Kontaktelemente sind jeweils in zugehörigen Differential-Pair-Kontakthohlräumen 31b und innerhalb von zugehörigen Isolierhohlräumen der Differential-Pair-Isolierkörper 32b angeordnet. Power-Kontaktelemente sind in dem Power-Kontakthohlraum 31c und innerhalb von zugehörigen Isolierhohlräumen des Power-Isolierkörpers 32c angeordnet.

Im montierten Zustand, in dem das rechnerseitige Verbinderelement 10 mit dem kartenseitigen Verbinderelement 30 verbunden und/oder zusammengesteckt ist, kontaktieren sich die rechnerseitigen Kontaktelemente 13a-13c und die kartenseitigen Kontaktelemente in den kartenseitigen Kontakthohlräumen 31a-31c und in den Isolierhohlräumen der kartenseitigen Isolierkörper 32a-32c.

Das rechnerseitige Gehäuse 20 kann eine Mehrzahl von Stabilisierungselementen aufweisen, während das kartenseitige Gehäuse 40 eine entsprechende Anzahl von komplementären Stabilisierungselementen aufweisen kann. Beim Zusammenstecken des rechnerseitigen Verbinderelements 10 und des kartenseitigen Verbinderelements 30 greifen die Stabilisierungselemente ineinander ein und stabilisieren die Steckverbindung im montierten Zustand. Zusätzlich können die Stabilisierungselemente auch als Steckhilfe dienen.

Das kartenseitige Gehäuse 40 weist zudem zumindest ein Führungselement 52, z.B. einen Vorsprung, auf, welcher beim Zusammenstecken des rechnerseitigen Verbinderelements 10 und des kartenseitigen Verbinderelements 30 in ein komplementäres Führungselement 54 des rechnerseitigen Gehäuses 10 eingreift. Dabei kann eines der Führungselemente 52 länglich ausgebildet sein, etwa parallel zur ersten Montagerichtung M1 ausgerichtet sein und/oder sich in Richtung zum zugeordneten Verbinderelement 10 bzw. 30 hin verjüngend ausgebildet sein. Dies erleichtert das Ausrichten des rechnerseitigen und kartenseitigen Verbinderelements 10 und 30 beim Zusammenstecken und somit die Montage des Verbindersystems 100.

Das rechnerseitige Gehäuse 20 und das kartenseitige Gehäuse 40 sind jeweils aus Zinkdruckguss ausgebildet und gefertigt, in welchem die Kontakthohlräume 12a-12c bzw. 32a-32c vorgesehen sind. Dadurch kann bewirkt werden, dass die rechnerseitigen Kontaktelemente 13a-13c und die kartenseitigen Kontaktelemente nicht nur mechanisch geschützt sind, sondern auch elektrisch geschirmt sind, um elektromagnetische Störeinflüsse zu reduzieren und/oder zu vermeiden. Die Signalqualität kann dadurch signifikant erhöht werden.

Ferner kann das kartenseitige Gehäuse 40 ein Federelement aufweisen, welches das kartenseitige Gehäuse 40 elektrisch kontaktiert und welches ausgelegt ist, um im montierten Zustand auch das rechnerseitige Gehäuse 20 elektrisch zu kontaktieren. Somit besteht ein elektrischer Kurzschluss zwischen den beiden Gehäusen 20 und 40, was die Schirmung der Kontaktelemente und damit die Signalqualität weiter verbessert.

Das rechnerseitige Verbinderelement 10 und das kartenseitige Verbinderelement 30 können z.B. eine Länge (etwa senkrecht zu den beiden Montagerichtungen M1 und M2) von etwa 85 mm, eine Tiefe (etwa parallel zur ersten Montagerichtung M1) von etwa 15 mm und eine Höhe (etwa parallel zur zweiten Montagerichtung M2) von etwa 12 mm aufweisen. Diese Abmessungen sind lediglich beispielhaft für den Automotive-Bereich und können je nach Anwendung auch andere für den Automotive Bereich geeignete Dimensionen einnehmen.

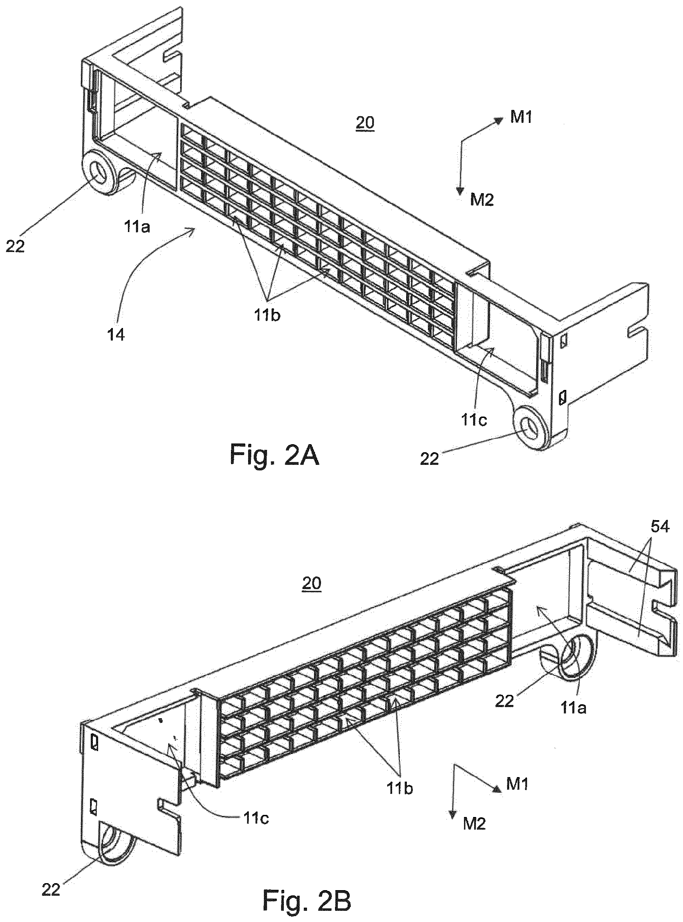

Die **Figur 2A** zeigt in einer ersten perspektivischen Ansicht (schräge Vorderansicht) eine schematische Skizze des rechnerseitigen Gehäuses 20 des in Figur 1 gezeigten Verbindersystems 100, während die **Figur 2B** das rechnerseitige Gehäuse 20 in einer zweiten perspektivischen Ansicht (schräge Rückansicht) zeigt. In den Figuren 2A und 2B sind nochmals die Kontakthohlräume 11a-11c gezeigt, welche das rechnerseitige Gehäuse 20 vollständig durchdringen und einen etwa rechteckigen Querschnitt aufweisen.

Wie in den Figuren 2A und 2B gezeigt, weist insbesondere jeder einzelne der Kontakthohlräume 11b einen etwa rechteckigen Querschnitt auf zum drehfesten Aufnehmen der Differential-Pair-Isolierkörper 12b. Beim Zusammenstecken des rechnerseitigen Verbinderelements 10 und des kartenseitigen Verbinderelements 30, d.h. im montierten Zustand, werden von den rechnerseitigen Kontakthohlräume 11a-11c und den kartenseitigen Kontakthohlräume 31a-31c zusammen durchgängige Kanäle und/oder Hohlräume für die Kontaktelemente ausgebildet.

Im montierten Zustand können die beiden Gehäuse 20 und 40 aneinander gekoppelt und/oder elektrisch kontaktiert sein, was die Schirmung verbessert.

Eine erste Schrauböffnung 22 ist benachbart zum rechnerseitigen Single-End Kontakthohlraum 11a am rechnerseitigen Gehäuse 20 ausgebildet. Eine zweite Schrauböffnung 22 ist benachbart zum rechnerseitigen Power Kontakthohlraum 11c am rechnerseitigen Gehäuse 20 ausgebildet.

Jede Schrauböffnung 22 ist als (z.B. flächige) Vergrößerung der rechnerseitigen Steckseite 14 ausgebildet und kann schlaufenartig vom rechnerseitigen Gehäuse 20 abstehen. Im gezeigten Ausführungsbeispiel stehen die etwa kreisförmigen Umrandungen der Schrauböffnungen 22 in etwa in der zweiten Montagerichtung M2 vom rechnerseitigen Gehäuse 20 ab.

Auch das in Figur 1 gezeigte kartenseitige Gehäuse 40 kann Schrauböffnungen aufweisen (nicht in den Figuren gezeigt), welche als Zinkdruckguss-Elemente ausgebildet sein können und zum Verstärken der Verbindung des kartenseitigen Verbinderelements 30 mit der PCB-Karte dienen. Schrauböffnungen am kartenseitigen Gehäuse 40 können z.B. als Vergrößerung der kartenseitigen Steckseite 34 ausgebildet sein (vgl. Fig. 1).

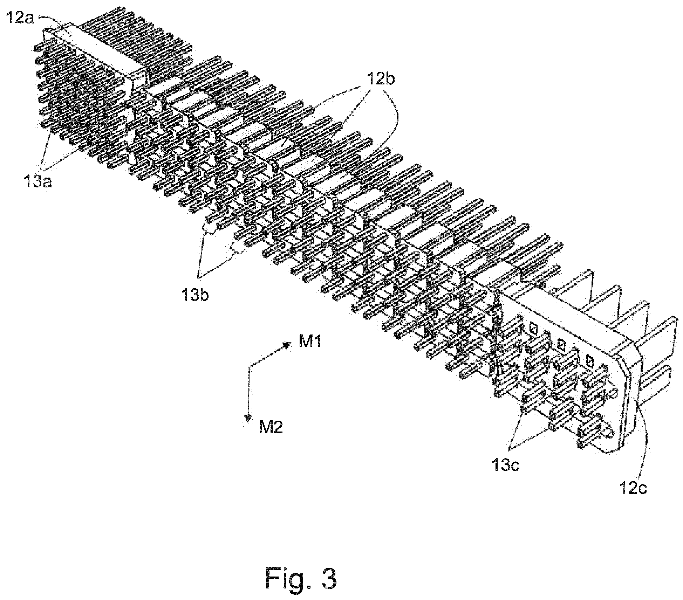

Die **Figur 3** zeigt eine schematische Skizze des rechnerseitigen Verbinderelements 10 aus Figur 1. Im Vergleich zur Figur 1 wurde in der Figur 3 z.B. das rechnerseitige Gehäuse 20 ausgeblendet, so dass die rechnerseitigen Isolierkörper 12a-12c und die rechnerseitigen Kontaktelemente 13a-13c besser gezeigt sind. Insbesondere ist in Figur 3 gezeigt, dass die hohlförmigen Isolierkörper 12a-12c die Kontaktelemente 13a-13c zumindest bereichsweise umgeben. Mit anderen Worten sind die Kontaktelemente 13a-13c zumindest bereichsweise innerhalb von Hohlräumen der Isolierkörper 12a-12c angeordnet.

### Bezugszeichenliste

- 10: rechnerseitiges Verbinderelement
- 11a: rechnerseitiger Single-End Kontakthohlraum
- 11b: rechnerseitiger Differential-Pair Kontakthohlraum
- 11c: rechnerseitiger Power Kontakthohlraum
- 12a: rechnerseitiger Single-End Isolierkörper
- 12b: rechnerseitiger Differential-Pair Isolierkörper
- 12c: rechnerseitiger Power Isolierkörper
- 13a: rechnerseitiges Single-End Kontaktelement
- 13b: rechnerseitiges Differential-Pair Kontaktelement
- 13c: rechnerseitiges Power Kontaktelement
- 14: rechnerseitige Steckseite
- 20: rechnerseitiges Gehäuse / Zinkdruckguss-Gehäuse
- 22: Schrauböffnung
- 30: kartenseitiges Verbinderelement
- 31a: kartenseitiger Single-End Kontakthohlraum
- 31b: kartenseitiger Differential-Pair Kontakthohlraum
- 31c: kartenseitiger Power Kontakthohlraum
- 32a: kartenseitiger Single-End Isolierkörper
- 32b: kartenseitiger Differential-Pair Isolierkörper
- 32c: kartenseitiger Power Isolierkörper
- 33a: kartenseitiges Single-End Kontaktelement
- 33b: kartenseitiges Differential-Pair Kontaktelement
- 33c: kartenseitiges Power Kontaktelement
- 34: kartenseitige Steckseite
- 40: kartenseitiges Gehäuse / Zinkdruckguss-Gehäuse
- 52: Führungselement
- 54: komplementäres Führungselement
- 100: Verbindersystem
- M1: erste Montagerichtung
- M2: zweite Montagerichtung

## Patentansprüche

1. Verwendung eines Verbindersystems (100) zum Verbinden einer PCB-Karte mit einem Zentralrechner eines Kraftfahrzeugs, wobei das Verbindersystem (100) ein rechnerseitiges Verbinderelement (10) und ein kartenseitiges Verbinderelement (30) aufweist, und wobei
das rechnerseitige Verbinderelement (10) aufweist:
- ein rechnerseitiges Zinkdruckguss-Gehäuse (20) mit zumindest einem rechnerseitigen Kontakthohlraum (11a-11c);
- zumindest einen rechnerseitigen Isolierkörper (12a-12c), welcher im montierten Zustand innerhalb des zumindest einen rechnerseitigen Kontakthohlrraums (11a-11c) angeordnet ist;
- eine Mehrzahl von rechnerseitigen Kontaktelementen (13a-13c), welche im montierten Zustand zumindest bereichsweise innerhalb von rechnerseitigen Isolierhohlräumen in dem zumindest einen rechnerseitigen Isolierkörper (12a-12c) angeordnet sind; und wobei
das kartenseitige Verbinderelement (30) aufweist:
- ein kartenseitiges Zinkdruckguss-Gehäuse (40) mit zumindest einem kartenseitigen Kontakthohlraum (31a-31c);
- zumindest einen kartenseitigen Isolierkörper (32a-32c), welcher im montierten Zustand innerhalb des zumindest einen kartenseitigen Kontakthohlraums (31a-31c) angeordnet ist und eine Mehrzahl kartenseitige Isolierhohlräume aufweist, die ausgelegt sind, um im montierten Zustand die rechnerseitigen Kontaktelemente (13a-13c) zumindest bereichsweise aufzunehmen;
- eine Mehrzahl von kartenseitigen Kontaktelementen, welche im montierten Zustand zumindest bereichsweise innerhalb der kartenseitigen Isolierhohlräume angeordnet sind und die rechnerseitigen Kontaktelemente (13a-13c) elektrisch kontaktieren.

2. Verwendung nach Anspruch 1, wobei zumindest ein Gehäuse vom rechnerseitigen Zinkdruckguss-Gehäuse (20) und vom kartenseitigen Zinkdruckguss-Gehäuse (40) zumindest eine Schrauböffnung (22) aufweist zum Festschrauben des jeweiligen Zinkdruckguss-Gehäuses (20; 40) an der PCB-Karte und/oder an dem Zentralrechner, wobei die Schrauböffnung (22) als eine Zinkdruckguss-Schrauböffnung ausgebildet ist.

3. Verwendung nach Anspruch 2 wobei die zumindest eine Schrauböffnung (22) parallel zur einer Einsteckrichtung des jeweiligen Zinkdruckguss-Gehäuses (20; 40) in die PCB-Karte und/oder den Zentralrechner ausgerichtet ist.

4. Verwendung nach Anspruch 2 oder 3, wobei das Zinkdruckguss-Gehäuse (20; 40) mit der Schrauböffnung (22) zumindest zwei Schrauböffnungen (22) aufweist.

5. Verwendung nach einem der vorangehenden Ansprüche, wobei das rechnerseitige Verbinderelement (10) ausgelegt ist, um entlang einer ersten Montagerichtung (M1) mit dem Zentralrechner verbunden zu werden, wobei das kartenseitige Verbinderelement (30) ausgelegt ist, um entlang einer zweiten Montagerichtung (M2) mit der PCB-Karte verbunden zu werden und wobei das rechnerseitige Verbinderelement (10) und das kartenseitige Verbinderelement (30) entlang der ersten Montagerichtung (M1) zusammensteckbar sind.

6. Verwendung nach Anspruch 5, wobei die kartenseitigen Kontaktelemente eine im Wesentlichen rechtwinklige Kante (K) aufweisen und im montierten Zustand derart angeordnet sind, so dass ein verbinderseitiger Abschnitt jedes kartenseitigen Kontaktelements im Wesentlichen parallel zur ersten Montagerichtung (M1) ausgebildet ist und ein kartenseitiger Abschnitt jedes kartenseitigen Kontaktelements im Wesentlichen parallel zur zweiten Montagerichtung (M2) ausgebildet ist, wobei die erste Montagerichtung (M1) im Wesentlichen senkrecht zur zweiten Montagerichtung (M2) angeordnet ist.

7. Verwendung nach Anspruch 6, wobei die im Wesentlichen rechtwinkligen Kanten (K) zumindest eines Teils der kartenseitigen Kontaktelemente auf einer Geraden in einer von der ersten und zweiten Montagerichtung (M1, M2) aufgespannten Ebene liegen, wobei die Gerade sowohl zur ersten Montagerichtung (M1) als auch zur zweiten Montagerichtung (M2) einen Winkel von etwa 45° aufweist.

8. Verwendung nach einem der vorangehenden Ansprüche, wobei das rechnerseitige Gehäuse (20) zumindest ein Eingriffelement aufweist, welches im montierten Zustand in zumindest ein komplementäres Eingriffelement des kartenseitigen Gehäuses (40) eingreift.

9. Verwendung nach einem der vorangehenden Ansprüche, wobei die kartenseitigen Kontaktelemente jeweils wellenförmige Endabschnitte aufweisen, um bei einem Überlapp mit einem zugehörigen rechnerseitigen Kontaktelement (13a-13c) das zugehörige rechnerseitige Kontaktelement (13a-13c) an zumindest zwei unterschiedlichen Stellen elektrisch zu kontaktieren.

10. Verwendung nach einem der vorangehenden Ansprüche,
wobei das rechnerseitige Gehäuse (20) zumindest ein Stabilisierungselement und das kartenseitige Gehäuse (40) zumindest ein komplementäres Stabilisierungselement aufweist, und/oder
wobei das kartenseitige Gehäuse (40) zumindest ein Führungselement (52) und das rechnerseitige Gehäuse (20) zumindest ein komplementäres Führungselement (54) aufweist.

11. Verwendung nach einem der vorangehenden Ansprüche, wobei das kartenseitige Gehäuse (40) Lötstellen aufweist, um auf die PCB-Karte gelötet zu werden.

12. Verwendung nach einem der vorangehenden Ansprüche, wobei
das rechnerseitige Gehäuse (20) einen rechnerseitigen Power-Kontakthohlraum (11c), einen rechnerseitigen Single-End-Kontakthohlraum (11a) und eine Mehrzahl von rechnerseitigen Differential-Pair-Kontakthohlräumen (11b) umfasst;
der zumindest eine rechnerseitige Isolierkörper (12a-12c) einen rechnerseitigen Power-Isolierkörper (12c), welcher im montierten Zustand in dem rechnerseitigen Power-Kontakthohlraum (11c) angeordnet ist, einen rechnerseitigen Single-End-Isolierkörper (12a), welcher im montierten Zustand in dem rechnerseitigen Single-End-Kontakthohlraum (11a) angeordnet ist, und eine Mehrzahl von rechnerseitigen Differential-Pair-Isolierkörpern (12b) umfasst, welche im montierten Zustand jeweils in einem zugehörigen rechnerseitigen Differential-Pair-Kontakthohlraum der Mehrzahl von rechnerseitigen Differential-Pair-Kontakthohlräumen (11b) angeordnet ist;
die Mehrzahl von rechnerseitigen Kontaktelementen (13a-13c) eine Mehrzahl von rechnerseitigen Power-Kontaktelementen (13c), welche im montierten Zustand zumindest bereichsweise in Isolierhohlräumen des rechnerseitigen Power-Isolierkörpers (12c) angeordnet sind, eine Mehrzahl von rechnerseitigen Single-End-Kontaktelementen (13a), welche im montierten Zustand zumindest bereichsweise in Isolierhohlräumen des rechnerseitigen Single-End-Isolierkörpers (12a) angeordnet sind, und eine Mehrzahl von rechnerseitigen Differential-Pair-Kontaktelementen (13b), welche im montierten Zustand jeweils zumindest bereichsweise in einem Isolierhohlraum eines zugehörigen rechnerseitigen Differential-Pair-Isolierkörpers der Mehrzahl von rechnerseitigen Differential-Pair-Isolierkörpern (12b) angeordnet sind, umfasst; und wobei
das kartenseitige Gehäuse (40) einen kartenseitigen Power-Kontakthohlraum (31c), einen kartenseitigen Single-End-Kontakthohlraum (31a) und eine Mehrzahl von kartenseitigen Differential-Pair-Kontakthohlräumen (31b) umfasst;
der zumindest eine kartenseitige Isolierkörper (32a-32b) einen kartenseitigen Power-Isolierkörper (32c), welcher im montierten Zustand in dem kartenseitigen Power-Kontakthohlraum (31c) angeordnet ist, einen kartenseitiges Single-End-Isolierkörper (32a), welcher im montierten Zustand in dem kartenseitigen Single-End-Kontakthohlraum (31a) angeordnet ist, und eine Mehrzahl von kartenseitigen Differential-Pair-Isolierkörpern (32b), welche im montierten Zustand jeweils in einem zugehörigen kartenseitigen Differential-Pair-Kontakthohlraum der Mehrzahl von kartenseitigen Differential-Pair-Kontakthohlräumen (31b) angeordnet ist, umfasst;
die Mehrzahl von kartenseitigen Kontaktelementen eine Mehrzahl von kartenseitigen Power-Kontaktelementen, welche im montierten Zustand zumindest bereichsweise in Isolierhohlräumen des kartenseitigen Power-Isolierkörpers (32c) angeordnet sind, eine Mehrzahl von kartenseitigen Single-End-Kontaktelementen, welche im montierten Zustand zumindest bereichsweise in Isolierhohlräumen des kartenseitigen Single-End-Isolierkörpers (32a) angeordnet sind, und eine Mehrzahl von kartenseitigen Differential-Pair-Kontaktelementen, welche im montierten Zustand jeweils zumindest bereichsweise in einem Isolierhohlraum eines zugehörigen kartenseitigen Differential-Pair-Isolierkörpers der Mehrzahl von kartenseitigen Differential-Pair-Isolierkörpern (32b) angeordnet sind, umfasst.

## Claims

1. Use of a connector system (100) for connecting a PCB card to a central computer of a motor vehicle, wherein the connector system (100) comprises a computer-side connector element (10) and a card-side connector element (30), and wherein
the computer-side connector element (10) comprises:
- a computer-side zinc die-cast housing (20) having at least one computer-side contact cavity (11a-11c);
- at least one computer-side insulating body (12a-12c), which, in the mounted state, is arranged inside the at least one computer-side contact cavity (11a-11c);
- a plurality of computer-side contact elements (13a-13c), which, in the mounted state, are arranged at least partially inside computer-side insulating cavities in the at least one computer-side insulating body (12a-12c); and wherein
the card-side connector element (30) comprises:
- a card-side zinc die-cast housing (40) having at least one card-side contact cavity (31a-31c);
- at least one card-side insulating body (32a-32c), which, in the mounted state, is arranged inside the at least one card-side contact cavity (31a-31c) and has a plurality of card-side insulating cavities that are configured to receive, in the mounted state, the computer-side contact elements (13a-13c) at least partially;
- a plurality of card-side contact elements, which, in the mounted state, are arranged at least partially inside the card-side insulating cavities and electrically contact the computer-side contact elements (13a-13c).

2. Use according to claim 1, wherein at least one housing of the computer-side zinc die-cast housing (20) and the card-side zinc die-cast housing (40) has at least one screw opening (22) for screwing the respective zinc die-cast housing (20; 40) to the PCB card and/or to the central computer, wherein the screw opening (22) is formed as a zinc die-cast screw opening.

3. Use according to claim 2, wherein the at least one screw opening (22) is aligned parallel to an insertion direction of the respective zinc die-cast housing (20; 40) into the PCB card and/or the central computer.

4. Use according to claim 2 or 3, wherein the zinc die-cast housing (20; 40) having the screw opening (22) has at least two screw openings (22).

5. Use according to one of the preceding claims, wherein the computer-side connector element (10) is configured to be connected to the central computer along a first mounting direction (M1), wherein the card-side connector element (30) is configured to be connected to the PCB card along a second mounting direction (M2), and wherein the computer-side connector element (10) and the card-side connector element (30) can be plugged together along the first mounting direction (M1).

6. Use according to claim 5, wherein the card-side contact elements have a substantially right-angled edge (K) and, in the mounted state, are arranged such that a connector-side section of each card-side contact element is formed substantially parallel to the first mounting direction (M1) and a card-side section of each card-side contact element is formed substantially parallel to the second mounting direction (M2), wherein the first mounting direction (M1) is arranged substantially perpendicular to the second mounting direction (M2).

7. Use according to claim 6, wherein the substantially right-angled edges (K) of at least a portion of the card-side contact elements lie on a straight line in a plane spanned by the first and second mounting directions (M1, M2), wherein the straight line has an angle of approximately 45° both with respect to the first mounting direction (M1) and with respect to the second mounting direction (M2).

8. Use according to one of the preceding claims, wherein the computer-side housing (20) has at least one engagement element which, in the mounted state, engages in at least one complementary engagement element of the card-side housing (40).

9. Use according to one of the preceding claims, wherein the card-side contact elements each have wave-shaped end sections in order, in the event of an overlap with an associated computer-side contact element (13a-13c), to electrically contact the associated computer-side contact element (13a-13c) at at least two different points.

10. Use according to one of the preceding claims,
wherein the computer-side housing (20) has at least one stabilizing element and the card-side housing (40) has at least one complementary stabilizing element, and/or
wherein the card-side housing (40) has at least one guide element (52) and the computer-side housing (20) has at least one complementary guide element (54).

11. Use according to one of the preceding claims, wherein the card-side housing (40) has soldering points in order to be soldered onto the PCB card.

12. Use according to one of the preceding claims, wherein
the computer-side housing (20) comprises a computer-side power contact cavity (11c), a computer-side single-end contact cavity (11a), and a plurality of computer-side differential-pair contact cavities (11b);
the at least one computer-side insulating body (12a-12c) comprises a computer-side power insulating body (12c), which, in the mounted state, is arranged in the computer-side power contact cavity (11c), a computer-side single-end insulating body (12a), which, in the mounted state, is arranged in the computer-side single-end contact cavity (11a), and a plurality of computer-side differential-pair insulating bodies (12b), which, in the mounted state, are each arranged in an associated computer-side differential-pair contact cavity of the plurality of computer-side differential-pair contact cavities (11b);
the plurality of computer-side contact elements (13a-13c) comprises a plurality of computer-side power contact elements (13c), which, in the mounted state, are arranged at least partially in insulating cavities of the computer-side power insulating body (12c), a plurality of computer-side single-end contact elements (13a), which, in the mounted state, are arranged at least partially in insulating cavities of the computer-side single-end insulating body (12a), and a plurality of computer-side differential-pair contact elements (13b), which, in the mounted state, are each arranged at least partially in an insulating cavity of an associated computer-side differential-pair insulating body of the plurality of computer-side differential-pair insulating bodies (12b); and wherein
the card-side housing (40) comprises a card-side power contact cavity (31c), a card-side single-end contact cavity (31a), and a plurality of card-side differential-pair contact cavities (31b);
the at least one card-side insulating body (32a-32b) comprises a card-side power insulating body (32c), which, in the mounted state, is arranged in the card-side power contact cavity (31c), a card-side single-end insulating body (32a), which, in the mounted state, is arranged in the card-side single-end contact cavity (31a), and a plurality of card-side differential-pair insulating bodies (32b), which, in the mounted state, are each arranged in an associated card-side differential-pair contact cavity of the plurality of card-side differential-pair contact cavities (31b);
the plurality of card-side contact elements comprises a plurality of card-side power contact elements, which, in the mounted state, are arranged at least partially in insulating cavities of the card-side power insulating body (32c), a plurality of card-side single-end contact elements, which, in the mounted state, are arranged at least partially in insulating cavities of the card-side single-end insulating body (32a), and a plurality of card-side differential-pair contact elements, which, in the mounted state, are each arranged at least partially in an insulating cavity of an associated card-side differential-pair insulating body of the plurality of card-side differential-pair insulating bodies (32b).

## Revendications

1. Utilisation d'un système de connecteurs (100) pour relier une carte PCB à un calculateur central d'un véhicule automobile, le système de connecteurs (100) présentant un élément de connecteur côté calculateur (10) et un élément de connecteur côté carte (30), et dans laquelle
l'élément de connecteur côté calculateur (10) présente :
- un boîtier côté calculateur en zinc moulé sous pression (20) avec au moins une cavité de contact côté calculateur (11a-11c) ;
- au moins un corps isolant côté calculateur (12a-12c), lequel, à l'état monté, est disposé à l'intérieur de l'au moins une cavité de contact côté calculateur (11a-11c) ;
- une pluralité d'éléments de contact côté calculateur (13a-13c), lesquels, à l'état monté, sont disposés au moins par zones à l'intérieur de cavités isolantes côté calculateur dans l'au moins un corps isolant côté calculateur (12a-12c) ; et dans laquelle
l'élément de connecteur côté carte (30) présente :
- un boîtier côté carte en zinc moulé sous pression (40) avec au moins une cavité de contact côté carte (31a-31c) ;
- au moins un corps isolant côté carte (32a-32c), lequel, à l'état monté, est disposé à l'intérieur de l'au moins une cavité de contact côté carte (31a-31c) et présente une pluralité de cavités isolantes côté carte, qui sont conçues pour recevoir, à l'état monté, les éléments de contact côté calculateur (13a-13c) au moins par zones ;
- une pluralité d'éléments de contact côté carte, lesquels, à l'état monté, sont disposés au moins par zones à l'intérieur des cavités isolantes côté carte et contactent électriquement les éléments de contact côté calculateur (13a-13c).

2. Utilisation selon la revendication 1, dans laquelle au moins un boîtier parmi le boîtier côté calculateur en zinc moulé sous pression (20) et le boîtier côté carte en zinc moulé sous pression (40) présente au moins une ouverture de vissage (22) destinée à visser le boîtier en zinc moulé sous pression respectif (20 ; 40) à la carte PCB et/ou au calculateur central, l'ouverture de vissage (22) étant réalisée sous la forme d'une ouverture de vissage en zinc moulé sous pression.

3. Utilisation selon la revendication 2, dans laquelle l'au moins une ouverture de vissage (22) est orientée parallèlement à une direction d'enfichage du boîtier en zinc moulé sous pression respectif (20 ; 40) dans la carte PCB et/ou dans le calculateur central.

4. Utilisation selon la revendication 2 ou 3, dans laquelle le boîtier en zinc moulé sous pression (20 ; 40) avec l'ouverture de vissage (22) présente au moins deux ouvertures de vissage (22).

5. Utilisation selon l'une quelconque des revendications précédentes, dans laquelle l'élément de connecteur côté calculateur (10) est conçu pour être relié au calculateur central le long d'une première direction de montage (M1), dans laquelle l'élément de connecteur côté carte (30) est conçu pour être relié à la carte PCB le long d'une seconde direction de montage (M2), et dans laquelle l'élément de connecteur côté calculateur (10) et l'élément de connecteur côté carte (30) peuvent être enfichés ensemble le long de la première direction de montage (M1).

6. Utilisation selon la revendication 5, dans laquelle les éléments de contact côté carte présentent une arête sensiblement à angle droit (K) et sont disposés, à l'état monté, de telle sorte qu'une section côté connecteur de chaque élément de contact côté carte est réalisée sensiblement parallèlement à la première direction de montage (M1) et qu'une section côté carte de chaque élément de contact côté carte est réalisée sensiblement parallèlement à la seconde direction de montage (M2), la première direction de montage (M1) étant disposée sensiblement perpendiculairement à la seconde direction de montage (M2).

7. Utilisation selon la revendication 6, dans laquelle les arêtes sensiblement à angle droit (K) d'au moins une partie des éléments de contact côté carte se situent sur une droite dans un plan défini par la première et la seconde direction de montage (M1, M2), ladite droite présentant, tant par rapport à la première direction de montage (M1) que par rapport à la seconde direction de montage (M2), un angle d'environ 45°.

8. Utilisation selon l'une quelconque des revendications précédentes, dans laquelle le boîtier côté calculateur (20) présente au moins un élément d'engagement, lequel, à l'état monté, s'engage dans au moins un élément d'engagement complémentaire du boîtier côté carte (40).

9. Utilisation selon l'une quelconque des revendications précédentes, dans laquelle les éléments de contact côté carte présentent chacun des sections d'extrémité ondulées afin, lors d'un chevauchement avec un élément de contact côté calculateur associé (13a-13c), de contacter électriquement l'élément de contact côté calculateur associé (13a-13c) en au moins deux endroits différents.

10. Utilisation selon l'une quelconque des revendications précédentes,
dans laquelle le boîtier côté calculateur (20) présente au moins un élément de stabilisation et le boîtier côté carte (40) présente au moins un élément de stabilisation complémentaire, et/ou
dans laquelle le boîtier côté carte (40) présente au moins un élément de guidage (52) et le boîtier côté calculateur (20) présente au moins un élément de guidage complémentaire (54).

11. Utilisation selon l'une quelconque des revendications précédentes, dans laquelle le boîtier côté carte (40) présente des points de soudure afin d'être soudé sur la carte PCB.

12. Utilisation selon l'une quelconque des revendications précédentes, dans laquelle
le boîtier côté calculateur (20) comprend une cavité de contact d'alimentation côté calculateur (11c), une cavité de contact Single-End côté calculateur (11a) et une pluralité de cavités de contact de paire différentielle côté calculateur (11b) ;
l'au moins un corps isolant côté calculateur (12a-12c) comprend un corps isolant d'alimentation côté calculateur (12c), lequel, à l'état monté, est disposé dans la cavité de contact d'alimentation côté calculateur (11c), un corps isolant Single-End côté calculateur (12a), lequel, à l'état monté, est disposé dans la cavité de contact Single-End côté calculateur (11a), et une pluralité de corps isolants de paire différentielle côté calculateur (12b), lesquels, à l'état monté, sont chacun disposés dans une cavité de contact de paire différentielle côté calculateur associée de la pluralité de cavités de contact de paire différentielle côté calculateur (11b) ;
la pluralité d'éléments de contact côté calculateur (13a-13c) comprend une pluralité d'éléments de contact d'alimentation côté calculateur (13c), lesquels, à l'état monté, sont disposés au moins par zones dans des cavités isolantes du corps isolant d'alimentation côté calculateur (12c), une pluralité d'éléments de contact Single-End côté calculateur (13a), lesquels, à l'état monté, sont disposés au moins par zones dans des cavités isolantes du corps isolant Single-End côté calculateur (12a), et une pluralité d'éléments de contact de paire différentielle côté calculateur (13b), lesquels, à l'état monté, sont chacun disposés au moins par zones dans une cavité isolante d'un corps isolant de paire différentielle côté calculateur associé de la pluralité de corps isolants de paire différentielle côté calculateur (12b) ; et dans laquelle le boîtier côté carte (40) comprend une cavité de contact d'alimentation côté carte (31c), une cavité de contact Single-End côté carte (31a) et une pluralité de cavités de contact de paire différentielle côté carte (31b) ;
l'au moins un corps isolant côté carte (32a-32b) comprend un corps isolant d'alimentation côté carte (32c), lequel, à l'état monté, est disposé dans la cavité de contact d'alimentation côté carte (31c), un corps isolant Single-End côté carte (32a), lequel, à l'état monté, est disposé dans la cavité de contact Single-End côté carte (31a), et une pluralité de corps isolants de paire différentielle côté carte (32b), lesquels, à l'état monté, sont chacun disposés dans une cavité de contact de paire différentielle côté carte associée de la pluralité de cavités de contact de paire différentielle côté carte (31b) ;
la pluralité d'éléments de contact côté carte comprend une pluralité d'éléments de contact d'alimentation côté carte, lesquels, à l'état monté, sont disposés au moins par zones dans des cavités isolantes du corps isolant d'alimentation côté carte (32c), une pluralité d'éléments de contact Single-End côté carte, lesquels, à l'état monté, sont disposés au moins par zones dans des cavités isolantes du corps isolant Single-End côté carte (32a), et une pluralité d'éléments de contact de paire différentielle côté carte, lesquels, à l'état monté, sont chacun disposés au moins par zones dans une cavité isolante d'un corps isolant de paire différentielle côté carte associé de la pluralité de corps isolants de paire différentielle côté carte (32b).
